# EUROPEAN PATENT APPLICATION

(11) **EP 4 790 108 A1**
(43) Date of publication of application: **12.08.2026**
(21) Application number: 24874699.2
(22) Date of filing: 03.10.2024
(51) Int. Cl.: C08L 101/00, B32B 15/08, C08F 220/02, C08K 3/013, C08K 3/38, C08K 7/00, C08L 33/04, C08L 63/00, H05K 1/03

(54) **RESIN COMPOSITION, INSULATING RESIN CURED PRODUCT, LAMINATE, AND CIRCUIT BOARD**

(30) Priority: 04.10.2023 JP 2023172910
(71) Applicant: Denka Company Limited, Tokyo 103-8338 (JP)
(72) Inventor: GONDA Yuhei, Tokyo 103-8338 (JP); KUMAGAI Ryota, Tokyo 103-8338 (JP); ICHIKAWA Isamu, Tokyo 103-8338 (JP); KOGURE Katsumichi, Tokyo 103-8338 (JP); NEBASHI Ibuki, Tokyo 103-8338 (JP)
(74) Representative: Hoffmann Eitle
(86) International application number: PCT/JP2024/035475
(87) International publication number: WO 2025/075099

(57) **Abstract**

Provided is a resin composition containing a thermosetting resin, an inorganic filler, and an inorganic ion scavenger, wherein: the inorganic filler includes first particles, which are scaly particles, and second particles, which are aggregated particles of scaly particles; the content of the first particles is 1 vol.% or more and 60 vol.% or less with respect to the total content of the first particles and the second particles; and the content of the inorganic ion scavenger is 0.1-50 mass% with respect to the total mass of the thermosetting resin.

## Description

### TECHNICAL FIELD

The present invention relates to: a resin composition which is preferably used in the production of an insulating layer of a circuit board (metal-based circuit board); an insulating resin cured product; a laminate; and a circuit board.

### BACKGROUND

Hitherto, various kinds of circuit boards have been utilized as circuit boards for forming hybrid integrated circuits having electronic/electric components such as semiconductor elements mounted thereon. Circuit boards are classified into resin circuit boards, ceramic circuit boards, and metal-based circuit boards, etc., on the basis of the circuit material.

Resin circuit boards are cheap but such boards have low thermal conductivity, and therefore, are limited to uses in which a relatively small amount of electricity is used. Since ceramics have characteristics of high electrical insulating properties and high heat resistance, ceramic circuit boards are suitable for uses in which a relatively large amount of electricity is used but have a drawback of being expensive. Meanwhile, metal-based circuit boards have intermediate properties between resin circuit boards and ceramic circuit boards, and are preferable for general purpose uses in which a relatively large amount of electricity is used, for example, uses such as in inverters for refrigerators, inverters for industrial air-conditioning, power supplies for industrial robots, and power supplies for vehicles, etc.

Patent Document 1, for example, discloses a method in which a circuit board composition having as essential components a specific epoxy resin, a curing agent, and an inorganic filler is used to obtain a circuit board which has excellent stress mitigation, heat resistance, humidity resistance, and heat dissipation properties.

### CITATION LIST

### PATENT LITERATURE

Patent Document 1: JP 2008-266533 A

### SUMMARY OF INVENTION

### TECHNICAL PROBLEM

If ceramic circuit boards could be substituted with metal-based circuit boards, then improvements in productivity could be anticipated. Further, ceramic circuit boards have an issue in that solder cracks appear on the board during heat cycles. However, by substituting ceramic circuit boards with metal-based circuit boards, it can be anticipated that the occurrence of solder cracks will be suppressed. Meanwhile, since ceramic circuit boards are suitable for applications used with relatively large electric power, when ceramic circuit boards are substituted with metal-based circuit boards, an improvement in insulating reliability (in particular, insulating reliability in high temperature conditions) with respect to applications of direct current high voltages is demanded of the metal-based circuit boards.

Thus, an objective of the present invention is to provide a resin composition capable of forming an insulating layer that has excellent insulating reliability with respect to applications of direct current high voltages in high temperature (150°C) conditions. Further, an objective of the present invention is to provide: an insulating resin cured product, which is a cured product of the resin composition; and a laminate and a circuit board which use the insulating resin cured product.

### SOLUTION TO PROBLEM

The present invention includes [1]-[13] below.
[1] A resin composition containing a thermosetting resin, an inorganic filler, and an inorganic ion scavenger, wherein:
   the inorganic filler includes first particles, which are scaly particles,
      and second particles, which are aggregated particles of scaly particles;
   the content of the first particles is 1 vol.% or more and 60 vol.% or
      less with respect to the total content of the first particles and the second particles; and
   the content of the inorganic ion scavenger is 0.1-50 mass% with respect to the total mass of the thermosetting resin.
[2] The resin composition described in [1], wherein the average aspect ratio of the first particles is 1-200, and the average aspect ratio of the second particles is1-2.
[3] The resin composition described in [1] or [2], wherein:
   the first particles are boron nitride particles and have a ratio I(002)/I(100) of a peak intensity I(002) of a (002) surface and a peak intensity I(100) of a (100) surface in an X-ray diffraction measurement of 50-1000; and
   the second particles are boron nitride particles and have a ratio I(002)/I(100) of a peak intensity I(002) of a (002) surface and a peak intensity I(100) of a (100) surface in an X-ray diffraction measurement of 1-20.
[4] The resin composition described in any one of [1]-[3], wherein a ratio of the average particle diameter of the first particles and the average particle diameter of the second particles is 1.5 or more and 20 or less.
[5] The resin composition described in any one of [1]-[4], wherein a ratio of the average aspect ratio of the first particles and the average aspect ratio of the second particles is 0.01 or more and 0.8 or less.
[6] The resin composition described in any one of [1]-[5], wherein the inorganic filler has a thermal conductivity of 20 W/m·K or more.
[7] The resin composition described in any one of [1]-[6], wherein the content of the inorganic filler is 30-70 vol.% with respect to the total volume of the resin composition.
[8] The resin composition described in any one of [1]-[7], wherein the inorganic ion scavenger includes both an anion exchanger and a cation exchanger, or an amphoteric ion exchanger.
[9] The resin composition described in any one of [1]-[8], wherein the inorganic ion scavenger includes at least one selected from the group consisting of Al, Mg, Bi, Zr, Sb, and Zn.
[10] The resin composition described in any one of [1]-[9], wherein the inorganic ion scavenger includes at least one selected from the group consisting of Bi, Zr, Sb, and Zn.
[11] The resin composition described in any one of [1]-[10], wherein the resin composition has a peak in the range of 2θ=11° to 15° in an X-ray diffraction measurement.
[12] The resin composition described in any one of [1]-[11], wherein the thermosetting resin is an epoxy resin.
[13] The resin composition described in any one of [1]-[12], wherein
   the resin composition further contains a copolymer, and
   the copolymer has: a (meth)acrylic monomeric unit A having an anionic group; a (meth)acrylic monomeric unit B having a cationic group; and a (meth)acrylic monomeric unit C other than the (meth)acrylic monomeric unit A and the (meth)acrylic monomeric unit B.
[14] An insulating resin cured product, which is a cured product of the resin composition described in any one of [1]-[13].
[15] A laminate including a first metal layer, an insulating layer disposed on one surface of the first metal layer, and a second metal layer disposed on a surface on the opposite side of the insulating layer to the first metal layer,
   wherein the insulating layer is the insulating resin cured product described in [14].
[16] A circuit board including a metal layer, an insulating layer disposed on one surface of the metal layer, and a metal circuit part disposed on a surface on the opposite side of the insulating layer to the metal layer,
   wherein the insulating layer is the insulating resin cured product described in [14].

### EFFECTS OF INVENTION

According to the present invention, there is provided a resin composition capable of forming an insulating layer that has excellent insulating reliability with respect to applications of direct current high voltages in high temperature (150°C) conditions. Further, according to the present invention, there is provided: an insulating resin cured product, which is a cured product of the resin composition; and a laminate and a circuit board which use the insulating resin cured product.

### BRIEF DESCRIPTION OF DRAWINGS

FIG. 1 is a cross-sectional view showing one embodiment of a laminate.
FIG. 2 is a cross-sectional view showing one embodiment of a circuit board.

### DESCRIPTION OF EMBODIMENTS

Preferred embodiments of the present invention will be described in detail below.

One embodiment of the present invention is a resin composition containing a thermosetting resin, an inorganic filler, and an inorganic ion scavenger.

Examples of a thermosetting resin include silicone resins, epoxy resins, phenol resins, cyanate resins, melamine resins, urea resins, thermosetting polyimide resins, and unsaturated polyester resins, etc. The thermosetting resin may include an epoxy resin. The thermosetting resin may be used alone or as a combination of two or more.

From the viewpoint that it is easy to obtain a resin composition capable of forming an insulating layer that has more excellent insulating reliability with respect to applications of direct current high voltages in high temperature (150°C) conditions, the content of the thermosetting resin may be 10 mass% or more, 20 mass% or more, or 25 mass% or more with respect to the total mass of the resin composition. From the viewpoint of improving thermal conductivity, the content of the thermosetting resin may be 50 mass% or less, 40 mass% or less, or 30 mass% or less with respect to the total mass of the resin composition. From the foregoing viewpoints, the content of the thermosetting resin may be 10-50 mass% with respect to the total mass of the resin composition.

The resin composition contains an inorganic filler. The inorganic filler may be a publicly-known inorganic filler that is used applications demanding insulating properties and thermal conductivity (however, inorganic fillers corresponding to the inorganic ion scavengers described later are excluded). The inorganic filler may, for example, include one or more selected from the group consisting of aluminum oxide (alumina), silicon oxide, silicon nitride, boron nitride, aluminum nitride, and magnesium oxide, and from the viewpoint that insulating reliability in high humidity environments is even more excellent, may include one or more selected from the group consisting of aluminum oxide, silicon oxide, silicon nitride, boron nitride, and aluminum nitride, and may include one or more selected from the group consisting of aluminum oxide, boron nitride, and aluminum nitride.

The inorganic filler includes first particles, which are scaly particles, and second particles, which are aggregated particles of scaly particles. The inorganic filler may include particles (third particles) which do not correspond to the first particles or the second particles. Further, the content of the first particles is 1 vol.% or more and 60 vol.% or less with respect to the total content of the first particles and the second particles.

Since the inorganic filler includes first particles, which are scaly particles, and second particles, which are aggregated particles of scaly particles, and the content of the first particles is 1 vol.% or more and 60 vol.% or less with respect to the total content of the first particles and the second particles, it is easy to obtain a resin composition capable of forming an insulating layer that has excellent insulating reliability with respect to applications of direct current high voltages in high temperature (150°C) conditions. Regarding the reasons therefor, the present inventors made the following inferences. That is, since the inorganic filler includes a plurality of particles having different shapes, filling properties of the inorganic filler improve and it is easy to restrict the movement of ions which have an effect on insulating properties. Further, since the second particles, which are particles having a relatively complex shape, are present at a certain content level, it is easy to adequately restrict the movement of ions which have an effect on insulating properties. For the foregoing reasons, it is inferred that the movement of ions in the resin composition is restricted and that the ions are also easily scavenged by an inorganic ion scavenger, and therefore, the insulating properties of an insulating layer formed from the resin composition improve. However, the mechanisms of the present invention are not limited to the reasons described above.

The first particles and the second particles may each include the same components or may include different components. The first particles and the second particles may each have the same constitution. For example, the first particles and the second particles may each be boron nitride particles. The second particles may be aggregated particles of the first particles, or may be aggregated particles of scaly particles different from the first particles. Herein, aggregated particles means a mass of particles in which a plurality of particles are in contact with one another.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the particle diameter of the first particles may be 50 µm or less, 30 µm or less, 15 µm or less, 10 µm or less, or 8 µm or less, and from the same viewpoints, may be 0.1 µm or more, 1 µm or more, 3 µm or more, or 5 µm or more. The particle diameter of the first particles is obtained by preparing a sample for cross-section observation by embedding the first particles in a resin, subjecting to mechanical polishing and an ion milling process, gold-plating depositing the sample, and then measuring the maximum length of the particles when the particles are observed at a magnification of 10,000 with a scanning electron microscope (SEM). From the foregoing viewpoints, the particle diameter of the first particles may be 0.1-50 µm.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the average particle diameter of the first particles may be 50 µm or less, 30 µm or less, 15 µm or less, 10 µm or less, or 8 µm or less, and from the same viewpoints, may be 0.1 µm or more, 1 µm or more, 3 µm or more, or 5 µm or more. The average particle diameter of the first particles is obtained by measuring and averaging the respective maximum lengths of ten first particles in one view when observed with an SEM in the method for measuring the particle diameter of the first particles described above. From the foregoing viewpoints, the average particle diameter of the first particles may be 0.1-50 µm.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the aspect ratio of the first particles may be 1-200, 5-200, 10-200, or 50-150. The aspect ratio of the first particles is obtained by: measuring the maximum length of the first particles and the maximum length in a direction perpendicular to the direction having the maximum length in the method for measuring the particle diameter of the first particles described above; and dividing the maximum length by the maximum length in the direction perpendicular to the direction having the maximum length. When the first particles are scaly, the aspect ratio is obtained by: measuring the maximum length and the maximum thickness (maximum length in the thickness direction) of the first particles in the method for measuring the particle diameter of the first particles described above; and dividing the maximum length by the maximum thickness.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the average aspect ratio of the first particles may be 1-200, 5-200, 10-200, or 50-150. The average aspect ratio of the first particles is obtained by: measuring, for ten particles in one view when observed with an SEM in the method for measuring the particle diameter of the first particles described above, the maximum length of the first particles and the maximum length thereof in a direction perpendicular to the direction having the maximum length; and dividing the maximum length by the maximum length in the direction perpendicular to the direction having the maximum length. When the first particles are scaly particles, the average aspect ratio of the first particles is obtained by measuring the maximum length and the maximum thickness of ten first particles in one view when observed with an SEM in the method for measuring the particle diameter of the first particles described above, dividing the maximum length by the maximum thickness, and averaging.

When the first particles include boron nitride particles (first boron nitride particles), a ratio I(002)/I(100) of a peak intensity I(002) of a (002) surface and a peak intensity I(100) of a (100) surface in an X-ray diffraction measurement of the first boron nitride particles may be 50-1000, 60-800, 70-600, 80-400, or 90-200.

The particle diameter of the second particles may be larger than the particle diameter of the first particles, and may be more than 8 µm, more than 10 µm, more than 15 µm, more than 30 µm, or more than 50 µm. The particle diameter of the second particles may be 500 µm or less, 300 µm or less, 200 µm or less, 150 µm or less, or 100 µm or less. The particle diameter of the second particles is obtained by preparing a sample for cross-section observation by embedding the second particles in a resin, subjecting to mechanical polishing and an ion milling process, gold-plating depositing the sample, and then measuring the maximum length of the particles when the particles are observed at a magnification of 1,000 with a scanning electron microscope (SEM). From the foregoing viewpoints, the particle diameter of the second particles may be more than 8 µm and 500 µm or less.

The average particle diameter of the second particles may be larger than the average particle diameter of the first particles, and may be more than 8 µm, more than 10 µm, more than 15 µm, more than 30 µm, or more than 50 µm. The average particle diameter of the second particles may be 500 µm or less, 300 µm or less, 200 µm or less, 150 µm or less, or 100 µm or less. The average particle diameter of the second particles can be measured by using a laser diffraction/scattering & dynamic image analysis-type particle diameter distribution/particle shape measurement device. From the foregoing viewpoints, the average particle diameter of the second particles may be more than 8 µm and 500 µm or less.

The aspect ratio of the second particles may be 1-5, 1-4, 1-3, or 1-2. The aspect ratio of the second particles is obtained by: measuring the maximum length of the second particles and the maximum length in a direction perpendicular to the direction having the maximum length in the method for measuring the particle diameter of the second particles described above; and dividing the maximum length by the maximum length in the direction perpendicular to the direction having the maximum length.

The average aspect ratio of the second particles may be 1-5, 1-4, 1-3, or 1-2. The average aspect ratio of the second particles can be measured by using a laser diffraction/scattering & dynamic image analysis-type particle diameter distribution/particle shape measurement device.

When the second particles include boron nitride particles (second boron nitride particles), a ratio I(002)/I(100) of a peak intensity I(002) of a (002) surface and a peak intensity I(100) of a (100) surface in an X-ray diffraction measurement of the second boron nitride particles may be 1-20, 1-15, 1-10, 1-5, 1.1-4, 1.2-3, or 1.2-2.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, a ratio (average particle diameter of second particles/average particle diameter of first particles) of the average particle diameter of the first particles and the average particle diameter of the second particles may be 1.5 or more, 2 or more, 3 or more, 4 or more, or 5 or more, and from the same viewpoints, may be 20 or less, 15 or less, 10 or less, 8 or less, or 6 or less. The ratio of the average particle diameter of the first particles and the average particle diameter of the second particles may be 1.5 or more and 20 or less, or may be 3 or more and 10 or less.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, a ratio (average aspect ratio of second particles/average aspect ratio of first particles) of the average aspect ratio of the first particles and the average aspect ratio of the second particles may be 0.01 or more, 0.05 or more, 0.1 or more, 0.15 or more, or 0.18 or more, and from the same viewpoints, may be 0.8 or less, 0.6 or less, 0.4 or less, 0.3 or less, or 0.2 or less. The ratio of the average aspect ratio of the first particles and the average aspect ratio of the second particles may be 0.01 or more and 0.8 or less, or may be 0.1 or more and 0.4 or less.

The inorganic filler may have a plurality of peaks in the particle size distribution curve. The inorganic filler may, for example, include a first particle group having a peak, in the particle size distribution curve, in the range of 0.1 µm or more and 15 µm or less, and a second particle group having a peak, in the particle size distribution curve, in the range of more than 15 µm and 300 µm or less. Note that herein, having a peak in a specific range in a particle size distribution curve means that there is a peak top within a specific range.

The first particle group may have a single peak or may have a plurality of peaks in the range of 0.1 µm or more and 15 µm or less in the particle size distribution curve. The second particle group may have a single peak or may have a plurality of peaks in the range of more than 15 µm and 300 µm or less in the particle size distribution curve.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the first particle group may have, in the particle size distribution curve, a peak in the range of 0.1 µm or more, 0.5 µm or more, 1 µm or more, 2 µm or more, 3 µm or more, 4 µm or more, or 5 µm or more, and from the same viewpoints, may have a peak in the range of 15 µm or less, 12 µm or less, 10 µm or less, 9 µm or less, 8 µm or less, or 7 µm or less. From the foregoing viewpoints, the first particle group may have a peak in the range of 0.1-15 µm.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the second particle group may have, in the particle size distribution curve, a peak in the range of more than 15 µm, more than 20 µm, more than 25 µm, more than 30 µm, more than 35 µm, or more than 40 µm, and from the same viewpoints, may have a peak in the range of 300 µm or less, 250 µm or less, 200 µm or less, 150 µm or less, 100 µm or less, 80 µm or less, 60 µm or less, or 50 µm or less. From the foregoing viewpoints, the second particle group may have a peak in the range of more than 15 µm and 300 µm or less.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, a difference ((position of peak that second particle group has) - (position of peak that first particle group has)) between a position (particle diameter) of a peak that the first particle group has in the particle size distribution curve and a position (particle diameter) of a peak that the second particle group has may be 10 µm or more, 20 µm or more, or 30 µm or more, and from the same viewpoints, may be 200 µm or less, 150 µm or less, 100 µm or less, or 50 µm or less. The difference between a position of a peak that the first particle group has and a position of a peak that the second particle group has may be 10 µm or more and 200 or less or may be 20 µm or more and 100 or less.

The thermal conductivity of the inorganic filler may be 20 W/m·K or more, 50 W/m·K or more, 100 W/m·K or more, or 150 W/m·K or more, and may be 3500 W/m·K or less, 2000 W/m·K or less, 1500 W/m·K or less, 600 W/m·K or less, 300 W/m·K or less, or 200 W/m·K or less. The thermal conductivity of the first particles may be within the ranges described above. The thermal conductivity of the second particles may be within the ranges described above.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the content of the first particles may be 2 vol.% or more, 3 vol.% or more, 5 vol.% or more, 8 vol.% or more, or 10 vol.% or more, and from the same viewpoints, may be 50 vol.% or less, 40 vol.% or less, 30 vol.% or less, 20 vol.% or less, or 15 vol.% or less with respect to the total content of the first particles and the second particles. The content of the first particles may be 1 vol.% or more and 50 vol.% or less, 3 vol.% or more and 30 vol.% or less, 3 vol.% or more and 30 vol.% or less, or 5 vol.% or more and 20 vol.% or less with respect to the total content of the first particles and the second particles.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the content of the second particles may be 50 vol.% or more, 60 vol.% or more, 70 vol.% or more, 80 vol.% or more, or 85 vol.% or more, and from the same viewpoints, may be 99 vol.% or less, 97 vol.% or less, 95 vol.% or less, 92 vol.% or less, or 90 vol.% or less with respect to the total content of the first particles and the second particles. The content of the second particles may be 50 vol.% or more and 99 vol.% or less, 60 vol.% or more and 97 vol.% or less, or 70 vol.% or more and 95 vol.% or less with respect to the total content of the first particles and the second particles.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the total content of the first particles and the second particles may be 50 mass% or more, 60 mass% or more, 70 mass% or more, 80 mass% or more, 90 mass% or more, or 95 mass% or more, and may substantially be 100 mass% with respect to the total mass of the inorganic filler.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the total content of the first particles and the second particles may be 50 vol.% or more, 60 vol.% or more, 70 vol.% or more, 80 vol.% or more, 90 vol.% or more, or 95 vol.% or more, and may substantially be 100 vol.% with respect to the total volume of the inorganic filler.

From the viewpoint of improving thermal conductivity, the content of the inorganic filler may be 30 mass% or more, 40 mass% or more, 50 mass% or more, or 60 mass% or more with respect to the total mass of the resin composition. From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the content of the inorganic filler is preferably 65 mass% or less. From the foregoing viewpoints, the content of the inorganic filler may be 30-80 mass% with respect to the total mass of the resin composition.

From the viewpoint of improving thermal conductivity, the content of the inorganic filler may be 20 vol.% or more, 30 vol.% or more, 40 vol.% or more, 45 vol.% or more, or 50 vol.% or more with respect to the total volume of the resin composition. From the viewpoint that it is easy to obtain a resin composition capable of forming an insulating layer that has more excellent insulating reliability with respect to applications of direct current high voltages in high temperature (150°C) conditions, the content of the inorganic filler may be 80 vol.% or less, 70 vol.% or less, 60 vol.% or less, 55 vol.% or less, or 50 vol.% or less with respect to the total volume of the resin composition. From the viewpoint that it is easy to obtain a resin composition capable of forming an insulating layer that has excellent insulating reliability with respect to applications of direct current high voltages in high temperature, high humidity (85°C, 85% RH) conditions, the content of the inorganic filler is preferably 55 vol.% or less. The content of the inorganic filler may be 20-80 vol.% or 30-70 vol.% with respect to the total volume of the resin composition. From the foregoing viewpoints, the content of the inorganic filler may be 30-80 vol.% with respect to the total volume of the resin composition.

An inorganic ion scavenger is an inorganic material having a function for scavenging cations and/or anions (having ion scavenging properties). Herein, "ion scavenging properties" means: a characteristic wherein ions which are a target for scavenging are adsorbed to a surface, etc., of an inorganic material; or a characteristic wherein by ion-exchanging ions within the structure of an inorganic material and ions which are a target for scavenging, the ions which are a target for scavenging are introduced into the structure of the inorganic material. Examples of ions which are a target for scavenging for the inorganic ion scavenger include cations such as Na ions, Cu ions, and Ag ions, etc., and anions such as Cl ions and Br ions, etc.

The inorganic ion scavenger may, for example, include at least one selected from the group consisting of Al, Mg, Bi, Zr, Sb, and Zn. From the viewpoint that it is easy to obtain a resin composition capable of forming an insulating layer that has more excellent insulating reliability with respect to applications of direct current high voltages in high temperature (150°C) conditions, the inorganic ion scavenger may include at least one selected from the group consisting of Al, Mg, Bi, Zr, Sb, and Zn, and from the viewpoint that it is easy to obtain a resin composition capable of forming an insulating layer that has excellent insulating reliability with respect to applications of direct current high voltages in high temperature, high humidity (85°C, 85% RH) conditions, the inorganic ion scavenger may include at least one selected from the group consisting of Bi, Zr, Sb, and Zn. The inorganic ion scavenger may, for example, be an oxide or an acid chloride including at least one of the foregoing metal elements, and may be a hydrate thereof, etc. The inorganic ion scavenger may include two or more of the foregoing metal elements.

Examples of the inorganic ion scavenger include anion exchangers which scavenge anions, cation exchangers which scavenge cations, and amphoteric ion exchangers which scavenge both anions and cations. The inorganic ion scavenger may be used alone or may be used as a combination of two or more. For example, an amphoteric ion exchanger may be a mixture of an anion exchanger and a cation exchanger. From the viewpoint that it is easy to obtain a resin composition capable of forming an insulating layer that has excellent insulating reliability with respect to applications of direct current high voltages in high temperature, high humidity (85°C, 85% RH) conditions, the inorganic ion scavenger may include both an anion exchanger and a cation exchanger or may include an amphoteric ion exchanger.

Examples of anion exchangers include inorganic ion materials including at least one selected from the group consisting of Al, Mg, Bi, Zr, and Zn. Specific examples of anion exchangers include IXE-500 (Bi-based), IXE-530 (Bi-based), IXE-550 (Bi-based), IXE-700 (Mg, Al-based), IXE-700F (Mg, Al-based), IXE-770 (Mg, Al-based), IXE-770D (Mg, Al-based), IXE-702 (Al-based), IXE-800 (Zr-based), and IXE-1000 (Zn-based) (all manufactured by Toagosei Co., Ltd.), etc.

Examples of cation exchangers include inorganic ion materials including at least one selected from the group consisting of Zr, Sn, and Ti. Specific examples of cation exchangers include IXE-100 (Zr-based), IXE-200 (Sn-based), IXE-300 (Sb-based), and IXE-400 (Ti-based) (all manufactured by Toagosei Co., Ltd.), etc.

Examples of amphoteric ion exchangers include inorganic materials including at least one selected from the group consisting of Al, Mg, Bi, Zr, and Sb. Specific examples of amphoteric ion exchangers include IXE-1320 (Mg, Al-based), IXE-600 (Sb, Bi-based), IXE-633 (Bi-based), IXE-680 (Bi-based), IXE-6107 (Zr, Bi-based), IXE-6136 (Zr, Bi-based), IXEPLAS-A1 (Zr, Mg, Al-based), IXEPLAS-A2 (Zr, Mg, Al-based), IXEPLAS-B1 (Zr, Bi-based) (all manufactured by Toagosei Co., Ltd.), etc.

The inorganic ion scavenger may be in a powder form. When the inorganic ion scavenger is in a powder form, the average particle diameter of the inorganic ion scavenger may be 0.05 µm or more, 0.1 µm or more, 0.15 µm or more, 0.2 µm or more, 0.3 µm or more, 0.4 µm or more, or 0.5 µm or more, and may be 10 µm or less, 5 µm or less, 3 µm or less, 2 µm or less, 1.5 µm or less, or 1 µm or less. The average particle diameter of the inorganic ion scavenger may be 0.05-10 µm. The average particle diameter of the inorganic ion scavenger can be measured by a laser diffraction/scattering method.

The content of an inorganic ion scavenger that includes at least one selected from the group consisting of Al, Mg, Bi, Zr, Sb, and Zn may be 80 mass% or more, 90 mass% or more, or 95 mass% or more with respect to the total mass of the inorganic ion scavenger. The content of an inorganic ion scavenger that includes at least one selected from the group consisting of Al, Mg, Bi, Zr, Sb, and Zn may substantially be 100 mass% with respect to the total mass of the inorganic ion scavenger.

The content of the inorganic ion scavenger is 0.1-50 mass% with respect to the total mass of the thermosetting resin. From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the content of the inorganic ion scavenger may be 0.3 mass% or more, 0.5 mass% or more, 1 mass% or more, 3 mass% or more, 5 mass% or more, 8 mass% or more, or 10 mass% or more, and may be 40 mass% or less, 30 mass% or less, 25 mass% or less, 20 mass% or less, or 15 mass% or less with respect to the total mass of the thermosetting resin.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the content of the inorganic ion scavenger may be 0.05 mass% or more, 0.1 mass% or more, 0.5 mass% or more, 1 mass% or more, 1.2 mass% or more, or 1.4 mass% or more, and may be 30 mass% or less, 20 mass% or less, 15 mass% or less, 10 mass% or less, 8 mass% or less, 6 mass% or less, or 4 mass% or less with respect to the total mass of the resin composition. From the foregoing viewpoints, the content of the inorganic ion scavenger may be 0.05-30 mass% with respect to the total mass of the resin composition.

From the viewpoint that it is easy to obtain a resin composition capable of forming an insulating layer that has more excellent insulating reliability with respect to applications of direct current high voltages in high temperature (150°C) conditions, and the viewpoint that it is easy to obtain a resin composition capable of forming an insulating layer that has excellent insulating reliability with respect to applications of direct current high voltages in high temperature, high humidity (85°C, 85% RH) conditions, the mass ratio (content of inorganic ion scavenger on basis of mass/content of copolymer on basis of mass) of the inorganic ion scavenger with respect to a copolymer may be 0.005 or more, 0.01 or more, or 0.05 or more, and may be 1000 or less , 100 or less, or 50 or less. The mass ratio of the inorganic ion scavenger with respect to the copolymer may be 25 or less, 10 or less, 5 or less, or 3 or less. The mass ratio of the inorganic ion scavenger with respect to the copolymer may be 0.001-10000.

The resin composition may further contain a dispersing agent for dispersing the inorganic filler. The dispersing agent may be a copolymer having: a (meth)acrylic monomeric unit A (hereinafter also referred to as a "unit A"; a monomer providing a unit A is also referred to as a "monomer A") having an anionic group; a (meth)acrylic monomeric unit B (hereinafter also referred to as a "unit B"; a monomer providing a unit B is also referred to as a "monomer B") having a cationic group; and a (meth)acrylic monomeric unit C (hereinafter also referred to as a "unit C"; a monomer providing a unit C is also referred to as a "monomer C") other than the (meth)acrylic monomeric unit A and the (meth)acrylic monomeric unit B. Note that the copolymer may have a (meth)acrylic monomeric unit (unit X) having both an anionic group and a cationic group. In such a case, the unit X is deemed to correspond to the unit A and also to correspond to the unit B. In other words, a copolymer having a unit X is deemed to have both a unit A and a unit B.

Herein, "monomer" means a monomer having a polymerizable group before polymerization. A "monomeric unit" means a structural unit that is derived from the monomer and constitutes a copolymer. A "(meth)acrylic monomer" means a monomer having a (meth)acryloyl group. A "(meth)acrylic monomer" means an acrylic monomer and a methacrylic monomer corresponding thereto. Similar expressions such as "(meth)acryloyl group", etc., also have the same meaning.

The copolymer has one or more of each of an A unit, a B unit, and a C unit. The copolymer may be a random copolymer or may be a block copolymer. The monomer A, the monomer B, and the monomer C may each be a monomer (monofunctional (meth)acrylic monomer) having one (meth)acryloyl group, or may be a monomer (multifunctional (meth)acrylic monomer) having two or more (meth)acryloyl groups. A monofunctional (meth)acrylic monomer is preferable.

The anionic group that the unit A has is, for example, one or more selected from the group consisting of a carboxyl group, a phosphate group, a phenolic hydroxyl group, and a sulfonic acid group. From the viewpoint of further improving dispersibility of the inorganic filler, the anionic group is preferably one or more selected from the group consisting of a carboxyl group, a phosphate group, and a phenolic hydroxyl group.

From the viewpoint of further improving the dispersibility of the inorganic filler, it is preferable that the unit A further has an electron-withdrawing group bound to the anionic group. The electron-withdrawing group has an action of stabilizing anions of the anionic group. An example of the electron-withdrawing group is a halogen group. An example of an anionic group having an electron-withdrawing group bound thereto is a group in which a halogen group is bound to a carbon atom at the α position of a carboxyl group.

The unit A does not have to have an electron donor group bound to the anionic group. An electron donor group may destabilize the anions of the anionic group. An example of an electron donor group is a methyl group.

Examples of the monomer A include acrylic acid, methacrylic acid, acid phosphoxy propyl methacrylate, acid phosphoxy polyoxyethylene glycol monomethacrylate, acid phosphoxy polyoxypropylene glycol monomethacrylate, phosphate-modified epoxy acrylate, 2-acryloyloxyethyl acid phosphate, 2-methacryloyl oxyethyl acid phosphate, 4-hydroxyphenyl acrylate, 4-hydroxyphenyl methacrylate, 2-methacryloyloxyethyl succinic acid, and 2-acrylamide-2-methylpropane sulfonic acid, etc. From the viewpoint of further improving the dispersibility of the inorganic filler, the monomer A is preferably one or more selected from the group consisting of acrylic acid, 2-methacryloyl oxyethyl acid phosphate, 4-hydroxyphenyl methacrylate, 2-acrylamide-2-methylpropane sulfonic acid, and more preferably is acrylic acid.

The cationic group that the unit B has is, for example, one or more selected from the group consisting of primary amino groups, secondary amino groups, tertiary amino groups, and quaternary ammonium bases. From the viewpoint of further improving the dispersibility of the inorganic filler, the cationic group is preferably a tertiary amino group.

From the viewpoint of further improving the dispersibility of the inorganic filler, it is preferable that the unit B further has an electron donor group bound to the cationic group. The electron donor group has an action of stabilizing cations of the cationic group. An example of an electron donor group is a methyl group. An example of a cationic group having an electron donor group bound thereto is a group in which a methyl group is bound to a carbon atom at the α position of an amino group.

The unit B does not have to have an electron-withdrawing group bound to the cationic group. An electron-withdrawing group may destabilize cations of the cationic group. An example of an electron-withdrawing group is a carboxyl group.

Examples of the monomer B include 1-amino ethyl acrylate, 1-amino propyl acrylate, 1-amino ethyl methacrylate, 1-amino propyl methacrylate, dimethyl amino ethyl methacrylate, diethyl aminoethyl methacrylate, t-butyl amino ethyl (meth)acrylate, dimethyl amino ethyl methacrylate quaternary salt, 1,2,2,6,6-pentamethyl-4-piperidyl methacrylate, 2,2,6,6-tetramethyl-4-piperidyl methacrylate, and dimethyl amino ethyl acrylate benzyl chloride quaternary salt, etc. From the viewpoint of further improving the dispersibility of the inorganic filler, the monomer B is preferably one or more selected from the group consisting of 1,2,2,6,6-pentamethyl-4-piperidyl methacrylate and 2,2,6,6-tetramethyl-4-piperidyl methacrylate, and more preferably is 1,2,2,6,6-pentamethyl-4-piperidyl methacrylate.

The unit C is a (meth)acrylic monomer that does not include either a cationic group or an anionic group. In addition to a (meth)acryloyl group, the unit C may have an amphipathic group, a hydrophobic group, or a hydrophilic group. An example of an amphipathic group is an oxyalkylene group. Examples of hydrophobic groups include siloxane groups and hydrocarbon groups. An example of a hydrophilic group is a phosphate ester group. Note that the hydrocarbon group herein does not include a methyl group constituting a methacryloyl group (the same also applies below with respect to the hydrocarbon group in the unit C).

From the viewpoint of affinity or compatibility between the copolymer and a resin when the resin composition further contains a resin, the unit C has one or more selected from the group consisting of oxyalkylene groups, siloxane groups, and hydrocarbon groups, and more preferably has one or more selected from the group consisting of siloxane groups and hydrocarbon groups.

Examples of a (meth)acrylic monomer having an oxyalkylene group include ethoxy carbonyl methyl (meth)acrylate, phenol ethylene oxide-modified (meth)acrylate, phenol (ethylene oxide 2 mole-modified) (meth)acrylate, phenol (ethylene oxide 4 mole-modified) (meth)acrylate, para-cumylphenol ethylene oxide-modified (meth)acrylate, nonylphenol ethylene oxide-modified (meth)acrylate, nonylphenol (ethylene oxide 4 mole-modified) (meth)acrylate, nonylphenol (ethylene oxide 8 mole-modified) (meth)acrylate, nonylphenol (propylene oxide 2.5 mole-modified) acrylate, 2-ethyl hexyl carbitol (meth)acrylate, ethylene oxide-modified phthalic acid (meth)acrylate, ethylene oxide-modified succinic acid (meth)acrylate, and tetrahydrofurfuryl (meth)acrylate.

Examples of a (meth)acrylic monomer having a siloxane group include α-butyl-ω-(3-methacryloxypropyl)polydimethyl siloxane. Examples of a (meth)acrylic monomer having a hydrocarbon group include methyl (meth)acrylate, ethyl (meth)acrylate, propyl (meth)acrylate, butyl (meth)acrylate, 2-ethyl hexyl (meth)acrylate, isooctyl (meth)acrylate, isodecyl (meth)acrylate, lauryl (meth)acrylate, stearyl (meth)acrylate, phenyl (meth)acrylate, cyclohexyl (meth)acrylate, dicyclopentanyl (meth)acrylate, dicyclopentenyl (meth)acrylate, dicyclopentenyloxyethyl (meth)acrylate, isobornyl (meth)acrylate, and methoxy cyclododecatriene (meth)acrylate.

Examples of a (meth)acrylic monomer having a phosphate ester group include (meth)acryloyloxy ethyl dialkyl phosphate.

Besides the foregoing, the monomer C may, for example, be a (meth)acrylic monomer having a hydroxy group. Examples of a (meth)acrylic monomer having a hydroxy group include 2-hydroxy ethyl (meth)acrylate, 2-hydroxy propyl (meth)acrylate, 3-hydroxy propyl (meth)acrylate, 4-hydroxy butyl (meth)acrylate, 2-hydroxy-3-phenoxypropyl (meth)acrylate, and 3-chloro-2-hydroxy propyl (meth)acrylate.

The monomer C may, for example, be a (meth)acrylic monomer having an amide bond. Examples of a (meth)acrylic monomer having an amide bond include N,N-dimethyl (meth)acrylamide, N,N-diethyl (meth)acrylamide, N-isopropyl (meth)acrylamide, diacetone (meth)acrylamide, and acryloyl morpholine.

The monomer C may, for example, be a multifunctional (meth)acrylic monomer. Examples of a multifunctional (meth)acrylic monomer include 1,3-butylene glycol di(meth)acrylate, 1,4-butanediol di(meth)acrylate, 1,6-hexadiol di(meth)acrylate, 1,9-nonanediol di(meth)acrylate, neopentyl glycol di(meth)acrylate, dicyclopentanyl di(meth)acrylate, 2-ethyl-2-butyl-propanediol (meth)acrylate, neopentyl glycol-modified trimethylolpropane di(meth)acrylate, stearic acid-modified pentaerythritol di(meth)acrylate, 2-(1,2-cyclohexacarboxyimide)ethyl(meth)acrylate, hexanediol di (meth)acrylate, and a multifunctional (meth)acrylate having a bisphenol structure.

The content of the unit A may be 0.03 mol% or more, 0.1 mol% or more, 0.5 mol% or more, 1 mol% or more, 2 mol% or more, 3 mol% or more, 4 mol% or more, or 5 mol% or more, and may be 70 mol% or less, 60 mol% or less, 50 mol% or less, 40 mol% or less, 30 mol% or less, 20 mol% or less, 15 mol% or less, 10 mol% or less, or 5 mol% or less with respect to the 100 mol% total of the unit A, the unit B, and the unit C (in other words, the total of all monomeric units that the copolymer has; same applies hereinafter). Due to the content of the unit A being 0.03 mol% or more, the dispersibility of the inorganic filler tends to improve further. Due to the content of the unit A being 70 mol% or less, there is a tendency for the viscosity of the resin composition to further decrease and for the handling properties of the resin composition to further improve.

The content of the unit B may be 0.02 mol% or more, 0.05 mol% or more, 0.07 mol% or more, or 0.1 mol% or more, and may be 20 mol% or less, 10 mol% or less, 5 mol% or less, 3 mol% or less, 1 mol% or less, 0.5 mol% or less, or 0.1 mol% or less with respect to the 100 mol% total of the unit A, the unit B, and the unit C. Due to the content of the unit B being 0.02 mol% or more, the affinity of the copolymer with respect to the inorganic filler tends to be better. Due to the content of the unit A being 70 mol% or less, there is a tendency for the viscosity of the resin composition to further decrease and for the handling properties of the resin composition to further improve.

The content of the unit C may be 10 mol% or more, 20 mol% or more, 30 mol% or more, 40 mol% or more, 50 mol% or more, 60 mol% or more, 70 mol% or more, 80 mol% or more, 90 mol% or more, 92 mol% or more, or 94 mol% or more, and may be 99.8 mol% or less, 99 mol% or less, 98 mol% or less, 97 mol% or less, 96 mol% or less, or 95 mol% or less with respect to the 100 mol% total of the unit A, the unit B, and the unit C. Due to the content of the unit C being 10 mol% or more, there is a tendency for the viscosity of the resin composition to further decrease and for the handling properties of the resin composition to further improve. Due to the content of the unit C being 99.8 mol% or less, the affinity of the copolymer with respect to the inorganic filler tends to be better.

The unit A and unit B total content may be 0.05 mol% or more, 0.2 mol% or more, 1 mol% or more, 2 mol% or more, 3 mol% or more, 4 mol% or more, or 5 mol% or more, and may be 90 mol% or less, 80 mol% or less, 70 mol% or less, 60 mol% or less, 50 mol% or less, 40 mol% or less, 30 mol% or less, 20 mol% or less, 10 mol% or less, 8 mol% or less, or 6 mol% or less with respect to the 100 mol% total of the unit A, the unit B, and the unit C. Due to the unit A and unit B total content being 0.05 mol% or more, the dispersibility of the inorganic filler tends to improve further. Due to the unit A and unit B total content being 90 mol% or less, there is a tendency for the handling properties of the resin composition to further improve.

The molar ratio (unit A/unit B) of the unit A with respect to the unit B content may be 0.01 or more, 0.9 or more, 1 or more, 5 or more, 10 or more, 20 or more, 30 or more, 40 or more, or 50 or more, and may be 200 or less, 150 or less, 100 or less, 90 or less, 80 or less, 70 or less, 60 or less, 50 or less, 40 or less, 30 or less, 20 or less, 15 or less, or 10 or less. Due to the molar ratio of the unit A with respect to the unit B being within the ranges described above, the dispersibility of the inorganic filler tends to improve further.

The weight-average molecular weight of the copolymer may be 1,000 or more, 5,000 or more, 7,000 or more, 10,000 or more, 20,000 or more, 30,000 or more, 40,000 or more, or 50,000 or more, and may be 1,000,000 or less, 500,000 or less, 300,000 or less, 100,000 or less, 90,000 or less, 80,000 or less, 70,000 or less, or 60,000 or less. Due to the weight-average molecular weight of the copolymer being 1,000 or more, even when the resin composition is stored for a long period of time in a high temperature environment, the dispersibility of the inorganic filler can be maintained and an increase in hardness of the resin composition can be suppressed. In addition, the shape retention properties of the resin composition improve and when coated on inclined surfaces or vertical surfaces, slipping and drooping of the resin composition are suppressed. Due to the weight-average molecular weight of the copolymer being 1,000,000 or less, there is a tendency for the viscosity of the resin composition to further decrease and for the handling properties of the resin composition to further improve. The weight-average molecular weight of the copolymer is determined as a standard polystyrene conversion weight-average molecular weight by using a gel permeation chromatography (GPC) method.

The copolymer is obtained by polymerizing the monomer A, the monomer B, and the monomer C using a publicly-known polymerization method. Examples of the polymerization method include radical polymerization and anionic polymerization. The polymerization method is preferably radical polymerization.

The polymerization initiator used in the radical polymerization may be a thermal polymerization initiator or a photopolymerization initiator. Examples of the thermal polymerization initiator include azo compounds such as azobisisobutyronitrile, etc., and organic peroxides such as benzoyl peroxide, tert-butylhydroperoxide, and di-tert-butyl peroxide, etc. Examples of the photopolymerization initiator include benzoin derivatives. The polymerization initiator may be a publicly-known polymerization initiator that is used in living radical polymerization such as ATRP, RAFT, etc.

Polymerization conditions can be adjusted, as appropriate, in accordance with the type of monomer, the polymerization initiator, etc. When the copolymer is a random copolymer, polymerization may be performed with the monomers being mixed in advance. When the copolymer is a block copolymer, the monomers may be added sequentially to the polymerization system.

The content of the copolymer may be 0.01-10 parts by mass with respect to 100 parts by mass of the inorganic filler. Due to the content of the copolymer being within the foregoing range, it is easy to obtain a resin composition capable of forming an insulating layer that has more excellent insulating reliability with respect to an application of a direct current high voltage in high temperature (150°C) conditions. The content of the copolymer may be 0.05 parts by mass or more, 0.1 parts by mass or more, 0.5 parts by mass or more, 1 part by mass or more, 2 parts by mass or more, 3 parts by mass or more, or 4 parts by mass or more, and may be 9 parts by mass or less, 8 parts by mass or less, 7 parts by mass or less, 6 parts by mass or less, 5 parts by mass or less, or 4 parts by mass or less with respect to 100 parts by mass of the inorganic filler.

The content of the copolymer may be 0.1 mass% or more, 0.5 mass% or more, 1 mass% or more, 2 mass% or more, or 2.5 mass% or more, and may be 10 mass% or less, 8 mass% or less, 6 mass% or less, 5 mass% or less, 4 mass% or less, or 3 mass% or less with respect to the total mass of the resin composition.

The resin composition may further contain a curing agent for curing the thermosetting resin. The curing agent is to be selected, as appropriate, in accordance with the type of thermosetting resin. Examples of a curing agent when the thermosetting resin is, for example, an epoxy resin include amine-based resins, anhydride-based resins, and phenol-based resins. The curing agent may be used alone or as a combination of two or more.

The content of the curing agent may be 1 mass% or more or 3 mass% or more and may be 10 mass% or less or 5 mass% or less with respect to the total mass of the resin composition.

The resin composition may further contain another component. Examples of the other component include curing accelerators, coupling agents, leveling agents, antioxidants, defoamants, wetting agents, dispersing agents, and stabilizers.

The resin composition is obtained by mixing the thermosetting resin, the inorganic filler, and the inorganic ion scavenger (and further, a dispersing agent, a curing agent, and other components which are used as necessary). The mixing may be performed by using, for example, a planetary stirrer, a universal mixer/stirrer, a kneader, a hybrid mixer, or the like.

The resin composition may have a peak in the range of 2θ=11° to 15° in an X-ray diffraction measurement. The peak position in an X-ray diffraction measurement of the resin composition can be confirmed by, for example, preparing a cured product of the resin composition and performing an X-ray diffraction measurement on the cured product. The resin composition may have a peak at a position of 2θ=11.5 to 14.5 or 11.8 to 14 in an X-ray diffraction measurement.

The resin composition described above can be prepared by mixing the thermosetting resin, the inorganic filler, the inorganic ion scavenger, and other components as necessary. The resin composition can be prepared by mixing, as the inorganic filler, a powder including at least scaly particles (first particles) and aggregated particles (second particles) of scaly particles, and a component other than the inorganic filler. Further, the resin composition can be prepared by preparing a powder including the first particles and a powder including the second particles, and then mixing the powders with a component other than the inorganic filler.

The resin composition may, for example, be cured and used. That is, one embodiment of the present invention is a cured product (insulating resin cured product) of the resin composition described above. The cured product may be in a semi-cured state (B stage) or may be in a fully-cured state (C stage).

The cured product is obtained by, for example, curing the resin composition described above by subjecting to a heat treatment. The conditions (heating temperature, heating time) of the heat treatment are to be set, as appropriate, in accordance with the types of thermosetting resin and curing agent, and the desired curing state, etc. The heat treatment may be performed in one stage or may be performed in two stages.

The cured product may, for example, be in a sheet form. A sheet-form cured product is obtained, for example, by coating the resin composition described above onto a substrate and heating (and applying pressure as necessary). The sheet-form cured product may be a B-stage sheet in a semi-cured state or may be a C-stage sheet in a fully-cured state.

The resin composition described above and the cured product thereof can be used preferably to form an insulating layer of a metal-based substrate. That is, the resin composition described above and the cured product thereof can also be referred to, respectively, as: a resin composition for a metal-based substrate; and a cured product for a metal-based substrate.

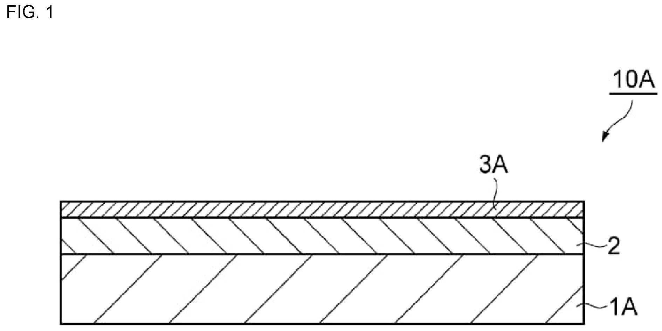

FIG. 1 is a schematic cross-sectional view showing one embodiment of a laminate. As shown in FIG. 1, a laminate 10A according to one embodiment includes: a first metal layer 1A; an insulating layer (cured product of the resin composition described above) 2 disposed on one surface the first metal layer; and a second metal layer 3A disposed on a surface on the opposite side of the insulating layer 2 to the first metal layer. In the laminate 10A, the first metal layer 1A and the second metal layer 3A are separated by the insulating layer 2, and thus, maintain a state of being electrically insulated from one another.

Examples of metal materials constituting the first metal layer 1A include aluminum, aluminum alloys, copper, copper alloys, iron, and stainless steel. The first metal layer 1A may be configured from one metal material or may be configured from two or more metal materials. The first metal layer 1A may be a single-layer structure or may be a multi-layer structure.

Examples of metal materials constituting the second metal layer 3A include copper, aluminum, and nickel. The second metal layer 3A may be configured from one metal material or may be configured from two or more metal materials. The second metal layer 3A may be a single-layer structure or may be a multi-layer structure. In FIG. 1, the second metal layer 3A is disposed substantially on the entire surface of the insulating layer 2. However, the second metal layer may be disposed on only a portion of the insulating layer 2.

The thickness of the first metal layer 1A may, for example, be 0.5 mm or more and may be 3 mm or less. The thickness of the insulating layer 2 may, for example, be 50 µm or more and may be 300 µm or less. The thickness of the second metal layer 3A may, for example, be 5 µm or more and may be 1 mm or less.

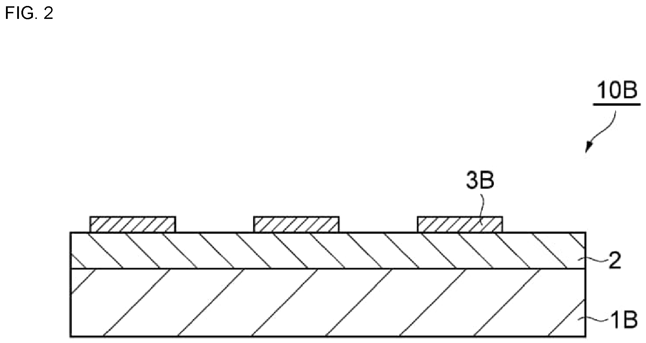

FIG. 2 is a schematic cross-sectional view showing one embodiment of a circuit board. As shown in FIG. 2, a circuit board 10B according to one embodiment includes: a metal layer 1B; an insulating layer (cured product of the resin composition described above) 2 disposed on one surface of the metal layer 1B; and a metal circuit part 3B disposed on a surface on the opposite side of the insulating layer 2 to the metal layer 1B. In the circuit board 10B, the metal circuit part 3B is, for example, a circuit having a prescribed pattern processed therein (by an etching process, for example).

Examples of metal materials constituting the metal layer 1B include the same metal materials as those constituting the first metal layer 1A described above. Examples of metal materials constituting the metal circuit part 3B include the same metal materials as those constituting the second metal layer 3A described above.

The thickness of the metal layer 1B may, for example, be 0.5 mm or more and may be 3 mm or less. The thickness of the insulating layer 2 may, for example, be 50 µm or more and may be 300 µm or less. The thickness of the metal circuit part 3B may, for example, be 5 µm or more and may be 1 mm or less.

### EXAMPLES

Hereinafter, the present invention is explained in further detail using examples, but the present invention is not limited to the examples below.

### <Synthesis of copolymer>

Monomers used in the synthesis of the copolymer of the examples are indicated below.
((Meth)acrylic monomer A having anionic group)
   · Acrylic acid (manufactured by Toagosei Co., Ltd.)
((Meth)acrylic monomer B having cationic group)
   · Methacrylic acid-1,2,2,6,6-pentamethyl-4-piperidyl methacrylate ("Adekastab LA-82" manufactured by Adeka Corporation)
((Meth)acrylic monomer C)
   · Benzyl methacrylate ("Light ester BZ" manufactured by Kyoeisha Chemical Co., Ltd.)

First, 100 parts by mass of a (meth)acrylic monomer including 5 mol% of acrylic acid, 0.1 mol% of methacrylic acid-1,2,2,6,6-pentamethyl-4-piperidyl methacrylate, and 94.9 mol% of benzyl methacrylate was added to an autoclave having an attached stirrer. Next, as an initiator, 0.5 parts by mass (with respect to a total 100 parts by mass of the (meth)acrylic monomer) of azobisisobutyronitrile (manufactured by Tokyo Chemical Industry Co., Ltd.) and, as a solvent, 1000 parts by mass of a mixed solution of toluene (special grade reagent) and 2-propanol (special grade reagent) (toluene:2-propanol=7:3 (volume ratio)) were added, and the autoclave interior was replaced with nitrogen). Thereafter, the autoclave was heated in an oil bath at 65°C for 20 hours and radical polymerization was performed. Upon completion of the polymerization, deaeration was performed for one hour at 120°C under reduced pressure to obtain a copolymer.

When analyzed by means of gas chromatography analysis, the polymerization rate with respect to 100% of the monomer incorporation amount was 98%. From the foregoing, the ratio of each monomeric unit that the copolymer has was inferred to be approximately the same as the monomer incorporation ratio.

The weight-average molecular weight of the obtained copolymer was determined as a standard polystyrene conversion weight-average molecular weight using a gel permeation chromatography (GPC) method. Note that the measurement conditions are as described below.
High-speed GPC device: "HLC-8020" manufactured by Tosoh Corporation
Columns: Total of three columns (total number of theoretical plates: 32000): one "TSK guard column MP(×L)" column, manufactured by Tosoh Corporation measuring 6.0 mm ID × 4.0 cm; and two "TSK-GEL MULTIPORE HXL-M" columns, manufactured by Tosoh Corporation measuring 7.8 mm ID × 30.0 cm (number of theoretical plates: 16000)
Developing solvent: Tetrahydrofuran
Detector: RI (differential refractometer)

### <Preparation of resin composition>

### (Example 1)

27.9 parts by mass of a naphthalene-type epoxy resin HP-4032D (manufactured by DIC Corporation) as a thermosetting resin and 3.5 parts by mass of a phenol novolak resin VH-4150 (manufactured by DIC Corporation) as a curing agent were stirred at 170°C to dissolve the curing agent in the thermosetting resin. The resin with the curing agent dissolved therein, 12.9 parts by mass (10 vol.%) of a boron nitride filler (thermal conductivity 150 W/m·K) as an inorganic filler, 2.6 parts by mass (4 phf) of the copolymer, 1.3 parts by mass (4.5 phr) of an inorganic ion scavenger 1 (amphoteric ion exchanger (Zr, Mg, Al-based), average particle diameter 0.2 µm, manufactured by Toagosei Co., Ltd.) as an inorganic ion scavenger, and 0.2 parts by mass of 1B2PZ (manufactured by Shikoku Chemical Corporation) as a curing accelerator were stir-mixed in a planetary mixer for 15 minutes to prepare a resin composition. The inorganic filler was a powder including 11.8 vol.% of scaly boron nitride particles (first particles, average particle diameter: 10.1 µm; average aspect ratio: 7.5; peak intensity ratio I(002)/I(100):126.4), and 88.2 vol.% of aggregated particles of scaly boron nitride particles (second particles, average particle diameter: 50.9 µm; average aspect ratio: 1.46; peak intensity ratio I(002)/I(100):6.8), the powder having, in a particle size distribution curve, a peak at a position of 6.6 µm and at a position of 43.5 µm.

### <Preparation of cured product>

The obtained resin composition was coated on a 0.038 mm-thick film made of polyethylene terephthalate (PET) so as to have a thickness, after curing, of 0.20 mm, and heated and dried for 50 minutes at 100°C to prepare a cured product in a semi-cured state (sheet in a B-stage state).

### <Fabrication of metal-based circuit board>

The prepared cured product (sheet in a B-stage state) was peeled away from the PET film, disposed on a roughened surface of a metal plate (copper plate having a thickness of 2.0 mm), and a roughened surface of a metal foil (copper foil having a thickness of 0.5 mm) was disposed on the cured product and heated and cured for 410 minutes at 180°C while a surface pressure of 10 MPa was applied by using a pressing machine.

Next, after masking a prescribed position using an etching resist, the copper foil was etched using a sulfuric acid-hydrogen peroxide mixed solution as an etching solution. The etching resist was removed and the cured product was washed and dried to obtain a metal-based circuit board having a round electrode (copper foil) with a diameter of 20 mm.

### (Example 2)

Apart from using an inorganic ion scavenger 2 (amphoteric ion exchanger (Zr, Bi-based), average particle diameter 0.4 µm, manufactured by Toagosei Co., Ltd.) as the inorganic ion scavenger, the same method as in Example 1 was used to prepare a resin composition, a cured product, and a metal-based circuit board.

### (Example 3)

Apart from using an inorganic ion scavenger 3 (anion exchanger (Mg, Al-based), average particle diameter 1.5 µm, manufactured by Toagosei Co., Ltd.) as the inorganic ion scavenger, the same method as in Example 1 was used to prepare a resin composition, a cured product, and a metal-based circuit board.

### (Example 4)

Apart from using an inorganic ion scavenger 4 (anion exchanger (Bi-based), average particle diameter 1.5 µm, manufactured by Toagosei Co., Ltd.) as the inorganic ion scavenger, the same method as in Example 1 was used to prepare a resin composition, a cured product, and a metal-based circuit board.

### (Example 5)

Apart from using an inorganic ion scavenger 5 (cation exchanger (Zr-based), average particle diameter 1.0 µm, manufactured by Toagosei Co., Ltd.) as the inorganic ion scavenger, the same method as in Example 1 was used to prepare a resin composition, a cured product, and a metal-based circuit board.

### (Example 6)

Apart from using an inorganic ion scavenger 6 (anion exchanger (Sb, Bi-based), average particle diameter 1.0 µm, manufactured by Toagosei Co., Ltd.) as the inorganic ion scavenger, the same method as in Example 1 was used to prepare a resin composition, a cured product, and a metal-based circuit board.

### (Example 7)

Apart from using an inorganic ion scavenger 6 (anion exchanger (Bi-based), average particle diameter 1.5 µm, manufactured by Toagosei Co., Ltd.) as the inorganic ion scavenger, the same method as in Example 1 was used to prepare a resin composition, a cured product, and a metal-based circuit board.

### (Example 8)

Apart from using, as the inorganic filler, a powder including 6.3 vol.% of scaly boron nitride particles (first particles, average particle diameter: 10.1 µm; average aspect ratio: 7.5; peak intensity ratio I(002)/I(100):126.4) and 93.7 vol.% of aggregated particles of scaly boron nitride particles (second particles, average particle diameter: 50.9 µm; average aspect ratio: 1.46; peak intensity ratio I(002)/I(100): 6.8), the powder having, in a particle size distribution curve, a peak at each of a position of 6.6 µm and of 43.5 µm, the same method as in Example 1 was used to prepare a resin composition, a cured product, and a metal-based circuit board.

### (Example 9)

Apart from using, as the inorganic filler, a powder including 55.3 vol.% of scaly boron nitride particles (first particles, average particle diameter: 10.1 µm; average aspect ratio: 7.5; peak intensity ratio I(002)/I(100):126.4) and 44.7 vol.% of aggregated particles of scaly boron nitride particles (second particles, average particle diameter: 50.9 µm; average aspect ratio: 1.46; peak intensity ratio I(002)/I(100): 6.8), the powder having, in a particle size distribution curve, a peak at each of a position of 6.6 µm and of 43.5 µm, the same method as in Example 1 was used to prepare a resin composition, a cured product, and a metal-based circuit board.

### (Example 10)

Apart from setting the amount of the inorganic ion scavenger so as to be 0.14 parts by mass (0.5 phr), the same method as in Example 1 was used to prepare a resin composition, a cured product, and a metal-based circuit board.

### (Example 11)

Apart from setting the amount of the inorganic ion scavenger so as to be 0.42 parts by mass (1.5 phr), the same method as in Example 1 was used to prepare a resin composition, a cured product, and a metal-based circuit board.

### (Example 12)

Apart from setting the amount of the inorganic ion scavenger so as to be 1.8 parts by mass (6 phr), the same method as in Example 1 was used to prepare a resin composition, a cured product, and a metal-based circuit board.

### (Example 13)

Apart from setting the amount of the inorganic ion scavenger so as to be 2.8 parts by mass (10 phr), the same method as in Example 1 was used to prepare a resin composition, a cured product, and a metal-based circuit board.

### (Example 14)

Apart from setting the amount of the inorganic ion scavenger so as to be 5.6 parts by mass (20 phr), the same method as in Example 1 was used to prepare a resin composition, a cured product, and a metal-based circuit board.

### (Comparative Example 1)

Apart from not adding an inorganic ion scavenger, the same method as in Example 1 was used to prepare a resin composition, a cured product, and a metal-based circuit board.

### (Comparative Example 2)

Apart from setting the amount of the inorganic ion scavenger so as to be 27.9 parts by mass (100 phr), the same method as in Example 1 was used to prepare a resin composition, a cured product, and a metal-based circuit board.

### (Comparative Example 3)

Apart from using, as the inorganic filler, a powder including 0.9 vol.% of aggregated particles of scaly boron nitride particles (first particles, average particle diameter: 50.9 µm; average aspect ratio: 1.46; peak intensity ratio I(002)/I(100): 6.8) and 99.1 vol.% of aggregated particles of scaly boron nitride particles (second particles, average particle diameter: 50.9 µm; average aspect ratio: 1.46; peak intensity ratio I(002)/I(100): 6.8), the powder having, in a particle size distribution curve, a peak at each of a position of 6.6 µm and of 43.5 µm, the same method as in Example 1 was used to prepare a resin composition, a cured product, and a metal-based circuit board.

### (Comparative Example 4)

Apart from using, as the inorganic filler, a powder including 77.1 vol.% of scaly boron nitride particles (first particles, average particle diameter: 10.1 µm; average aspect ratio: 7.5; peak intensity ratio I(002)/I(100):126.4) and 22.9 vol.% of aggregated particles of scaly boron nitride particles (second particles, average particle diameter: 50.9 µm; average aspect ratio: 1.46; peak intensity ratio I(002)/I(100): 6.8), the powder having, in a particle size distribution curve, a peak at each of a position of 6.6 µm and of 43.5 µm, the same method as in Example 1 was used to prepare a resin composition, a cured product, and a metal-based circuit board.

### [Measurement of particle size distribution]

The particle size distribution was measured by using a particle diameter distribution/particle shape analysis device (SYNC-3L S/N:H0153, manufactured by Microtrac) under the measurement conditions described below. Measurement of the particle size distribution involved substituting a circulation tank with a sodium hexametaphosphate aqueous solution, loading a sample into the circulation tank, stabilizing, and then performing measurement.

### <Measurement conditions>

Particle refractive index: 1.74
Particle shape: non-spherical
Solvent used: sodium hexametaphosphate aqueous solution
Solvent refractive index: 1.333
Flow velocity: 60%
Measurement time: 10 seconds (wet)

### [Measurement of average particle diameter/average aspect ratio]

For the scaly boron nitride particles, the average particle diameter and average aspect ratio were calculated by preparing a sample for cross-section observation by embedding the boron nitride particles in a resin and subjecting to mechanical polishing and an ion milling process, then performing gold-plating depositing on the prepared sample, observing a cross section at a magnification of 10,000 with a scanning electron microscope (SEM), measuring the maximum length and the maximum thickness of ten boron nitride particles in one view, and calculating the average value of the maximum length of the particles and the average value of maximum length/maximum thickness.

For the aggregated particles of scaly boron nitride particles, the particle size distribution was measured by using a particle diameter distribution/particle shape analysis device (SYNC-3L S/N:H0153, manufactured by Microtrac) under the measurement conditions described below. Measurement of the average particle diameter and the average aspect ratio involved substituting a circulation tank with a sodium hexametaphosphate aqueous solution, loading a sample in the circulation tank, stabilizing, and then performing measurement.

### <Measurement conditions>

Particle refractive index: 1.74
Particle shape: non-spherical
Solvent used: sodium hexametaphosphate aqueous solution
Solvent refractive index: 1.333
Measurement time: 10 seconds (wet)

### [Measurement of XRD peak]

For the cured products prepared in each example and comparative example, an X-ray diffraction measurement was performed using an X-ray diffraction device "Rigaku MiniFlexII" manufactured by Rigaku Corporation. Tables 1-4 show positions of the XRD peaks detected in a range of 2θ=11 to 15°. Further, the peak intensity ratio (I(002)/I(100)) of the boron nitride particles was measured in a range of 2θ=20° to 50°, with an intensity of a diffraction line near 2θ=27° being calculated as I(002) and an intensity of a diffraction line near 2θ=41° being calculated as I(100).

### [Evaluation of reliability by high-temperature high-pressure bias test (V-t)]

A high-temperature high-pressure bias test (V-t) was carried out on the obtained metal-based substrate wherein a time until insulation breakdown was measured in test conditions in which a direct current voltage of 10 kV was applied between the metal foil and the metal plate in a 150°C environment. The time from the initiation of voltage application to a time at which a leakage current value, as measured by a withstand voltage tester, become 10 mA or more was used as the time until insulation breakdown. The measurement results are shown in Tables 1-4.

### [Evaluation of reliability by high-temperature high-humidity bias test (THB)]

A high-temperature high-humidity bias test (THB) was carried out on the obtained metal-based substrate wherein a time until insulation breakdown was measured in test conditions in which a direct current voltage of 2.0 kV was applied between the metal foil and the metal plate in a 85°C, 85% RH environment. The time from the initiation of voltage application to a time at which a leakage current value, as measured by a withstand voltage tester, become 10 mA or more was used as the time until insulation breakdown. The measurement results are shown in Tables 1-4. Note that "-" shown in the tables indicates a case of being unmeasured.

**TABLE 1**

| | EXAMPLE 1 | EXAMPLE 2 | EXAMPLE 3 | EXAMPLE 4 | EXAMPLE 5 | EXAMPLE 6 | EXAMPLE 7 |
|---|---|---|---|---|---|---|---|
| CONTENT OF FIRST PARTICLE GROUP [VOL.%] | 11.8 | 11.8 | 11.8 | 11.8 | 11.8 | 11.8 | 11.8 |
| TYPE OF INORGANIC ION SCAVENGER | 1 | 2 | 3 | 4 | 5 | 6 | 7 |
| | AMPHOTERIC ION EXCHANGER | AMPHOTERIC ION EXCHANGER | ANION EXCHANGER | ANION EXCHANGER | CATION EXCHANGER | AMPHOTERIC ION EXCHANGER | AMPHOTERIC ION EXCHANGER |
| ELEMENTS CONTAINED IN INORGANIC ION SCAVENGER | Zr, Mg, Al | Zr, Bi | Mg, Al | Bi | Zr | Sb, Bi | Zr, Bi |
| INORGANIC ION SCAVENGER PARTICLE DIAMETER [µm] | 0.2 | 0.4 | 1.5 | 1.5 | 1 | 1 | 1.5 |
| CONTENT OF INORGANIC ION SCAVENGER [phr] | 4.5 | 4.5 | 4.5 | 4.5 | 4.5 | 4.5 | 4.5 |
| XRD PEAK DETECTED POSITION (2θ) [° ] | 12.51 | 11.93 | 13.69 | 13.92 | 11.98 | 13.97 | 11.91 |
| 150°C DC10kV V-t TEST BREAKDOWN TIME [h] | 64.4 | 81.6 | 7.1 | 2.9 | 27.9 | 34.5 | 69.8 |
| 85°C 85% 2.0 kV THB TEST BREAKDOWN TIME [h] | - | 254.7 | - | - | - | 91.6 | 186.4 |

**TABLE 2**

| | EXAMPLE 8 | EXAMPLE 9 |
|---|---|---|
| CONTENT OF FIRST PARTICLE GROUP [VOL.%] | 6.3 | 55.3 |
| TYPE OF INORGANIC ION SCAVENGER | 2 | 2 |
| | AMPHOTERIC ION EXCHANGER | AMPHOTERIC ION EXCHANGER |
| ELEMENTS CONTAINED IN INORGANIC ION SCAVENGER | Zr,Bi | Zr,Bi |
| INORGANIC ION SCAVENGER PARTICLE DIAMETER [µm] | 0.4 | 0.4 |
| CONTENT OF INORGANIC ION SCAVENGER [phr] | 4.5 | 4.5 |
| XRD PEAK DETECTED POSITION (2θ) [° ] | 11.93 | 11.93 |
| 150°C DC10kV V-t TEST BREAKDOWN TIME [h] | 10.5 | 15.6 |
| 85°C 85% 2.0 kV THB TEST BREAKDOWN TIME [h] | 65.1 | 73.2 |

**TABLE 3**

| | EXAMPLE 10 | EXAMPLE 11 | EXAMPLE 12 | EXAMPLE 13 | EXAMPLE 14 |
|---|---|---|---|---|---|
| CONTENT OF FIRST PARTICLE GROUP [VOL.%] | 11.8 | 11.8 | 11.8 | 11.8 | 11.8 |
| TYPE OF INORGANIC ION SCAVENGER | 2 | 2 | 2 | 2 | 2 |
| | AMPHOTERIC ION EXCHANGER | AMPHOTERIC ION EXCHANGER | AMPHOTERIC ION EXCHANGER | AMPHOTERIC ION EXCHANGER | AMPHOTERIC ION EXCHANGER |
| ELEMENTS CONTAINED IN INORGANIC ION SCAVENGER | Zr,Bi | Zr,Bi | Zr,Bi | Zr,Bi | Zr,Bi |
| INORGANIC ION SCAVENGER PARTICLE DIAMETER [µm] | 0.4 | 0.4 | 0.4 | 0.4 | 0.4 |
| CONTENT OF INORGANIC ION SCAVENGER [phr] | 0.5 | 1.5 | 6 | 10 | 20 |
| XRD PEAK DETECTED POSITION (2θ) [° ] | 11.93 | 11.93 | 11.93 | 11.93 | 11.93 |
| 150°C DC10kV V-t TEST BREAKDOWN TIME [h] | 2.2 | 16.8 | 84.7 | 196.3 | 38.3 |
| 85°C 85% 2.0 kV THB TEST BREAKDOWN TIME [h] | - | 96.5 | 379.1 | 385 | 493.5 |

**TABLE 4**

| | COMP EX 1 | COMP EX 2 | COMP EX 3 | COMP EX 4 |
|---|---|---|---|---|
| CONTENT OF FIRST PARTICLE GROUP [VOL.%] | 11.8 | 11.8 | 0.9 | 77.1 |
| TYPE OF INORGANIC ION SCAVENGER | - | 2 | 2 | 2 |
| | - | AMPHOTERIC ION EXCHANGER | AMPHOTERIC ION EXCHANGER | AMPHOTERIC ION EXCHANGER |
| ELEMENTS CONTAINED IN INORGANIC ION SCAVENGER | - | Zr,Bi | Zr,Bi | Zr,Bi |
| INORGANIC ION SCAVENGER PARTICLE DIAMETER [µm] | - | 0.4 | 0.4 | 0.4 |
| CONTENT OF INORGANIC ION SCAVENGER [phr] | 0 | 100 | 4.5 | 4.5 |
| XRD PEAK DETECTED POSITION (2θ) [° ] | - | 11.93 | 11.93 | 11.93 |
| 150°C DC10kV V-t TEST BREAKDOWN TIME [h] | 0.4 | 0.6 | 0.2 | 0.5 |
| 85°C 85% 2.0 kV THB TEST BREAKDOWN TIME [h] | 45.8 | 43.2 | 25.5 | 27.8 |

### REFERENCE SIGNS LIST

- 1A: First metal layer
- 1B: Metal layer
- 2: Insulating layer
- 3A: Second metal layer
- 3B: Metal circuit part
- 10A: Laminate
- 10B: Circuit board

## Claims

1. A resin composition containing a thermosetting resin, an inorganic filler, and an inorganic ion scavenger, wherein:
the inorganic filler comprises first particles, which are scaly particles, and second particles, which are aggregated particles of scaly particles;
the content of the first particles is 1 vol.% or more and 60 vol.% or less with respect to the total content of the first particles and the second particles; and
the content of the inorganic ion scavenger is 0.1-50 mass% with respect to the total mass of the thermosetting resin.

2. The resin composition according to claim 1, wherein the average aspect ratio of the first particles is 1-200, and the average aspect ratio of the second particles is 1-2.

3. The resin composition according to claim 1, wherein:
the first particles are boron nitride particles and have a ratio I(002)/I(100) of a peak intensity I(002) of a (002) surface and a peak intensity I(100) of a (100) surface in an X-ray diffraction measurement of 50-1000; and
the second particles are boron nitride particles and have a ratio I(002)/I(100) of a peak intensity I(002) of a (002) surface and a peak intensity I(100) of a (100) surface in an X-ray diffraction measurement of 1-20.

4. The resin composition according to claim 1, wherein a ratio of the average particle diameter of the first particles and the average particle diameter of the second particles is 1.5 or more and 20 or less.

5. The resin composition according to claim 1, wherein a ratio of the average aspect ratio of the first particles and the average aspect ratio of the second particles is 0.01 or more and 0.8 or less.

6. The resin composition according to claim 1, wherein the inorganic filler has a thermal conductivity of 20 W/m·K or more.

7. The resin composition according to claim 1, wherein the content of the inorganic filler is 30-70 vol.% with respect to the total volume of the resin composition.

8. The resin composition according to claim 1, wherein the inorganic ion scavenger comprises both an anion exchanger and a cation exchanger, or an amphoteric ion exchanger.

9. The resin composition according to claim 1, wherein the inorganic ion scavenger comprises at least one selected from the group consisting of Al, Mg, Bi, Zr, Sb, and Zn.

10. The resin composition according to claim 1, wherein the inorganic ion scavenger comprises at least one selected from the group consisting of Bi, Zr, Sb, and Zn.

11. The resin composition according to claim 1, wherein the resin composition has a peak in the range of 2θ=11°to 15°in an X-ray diffraction measurement.

12. The resin composition according to claim 1, wherein the thermosetting resin is an epoxy resin.

13. The resin composition according to claim 1, wherein
the resin composition further contains a copolymer, and
the copolymer has: a (meth)acrylic monomeric unit A having an anionic group; a (meth)acrylic monomeric unit B having a cationic group; and a (meth)acrylic monomeric unit C other than the (meth)acrylic monomeric unit A and the (meth)acrylic monomeric unit B.

14. An insulating resin cured product, which is a cured product of the resin composition according to any one of claims 1-13.

15. A laminate comprising a first metal layer, an insulating layer disposed on one surface of the first metal layer, and a second metal layer disposed on a surface on the opposite side of the insulating layer to the first metal layer,
wherein the insulating layer is the insulating resin cured product according to claim 14.

16. A circuit board comprising a metal layer, an insulating layer disposed on one surface of the metal layer, and a metal circuit part disposed on a surface on the opposite side of the insulating layer to the metal layer,
wherein the insulating layer is the insulating resin cured product according to claim 14.
